# EUROPEAN PATENT APPLICATION

(11) **EP 4 535 398 A1**
(43) Date of publication of application: **09.04.2025**
(21) Application number: 23814939.7
(22) Date of filing: 15.05.2023
(51) Int. Cl.: H01J 37/32

(54) **SEMICONDUCTOR PROCESS DEVICE**

(30) Priority: 31.05.2022 CN 202210609466
(71) Applicant: Beijing NAURA Microelectronics Equipment Co., Ltd., Beijing 100176 (CN)
(72) Inventor: YANG, Shuai, Beijing 100176 (CN); XIE, Yuanxiang, Beijing 100176 (CN); ZHANG, Bo, Beijing 100176 (CN)
(74) Representative: LifeTech IP Spies & Behrndt Patentanwälte PartG mbB
(86) International application number: PCT/CN2023/094167
(87) International publication number: WO 2023/231754

(57) **Abstract**

The present disclosure provides a semiconductor process device, and belongs to the field of semiconductor equipment. The semiconductor process device includes: a process pipe, a plurality of gas intake pipes, and a plurality of groups of electrode assemblies, a process chamber and a plurality of buffer chambers are formed inside the process pipe, the plurality of gas intake pipes correspondingly extend into the plurality of buffer chambers, an exhaust port communicated with the process chamber is provided at a sidewall of the process pipe, each of the buffer chambers is arranged corresponding to at least one group of electrode assemblies, and the electrode assemblies extend into the buffer chambers, and are connected to a radio frequency power supply; the electrode assembly includes a deformable electrode core, a plurality of electrode tubes, and an electrode mesh, the plurality of electrode tubes are sequentially arranged along an extension direction of the electrode core, a preset gap is provided between every two adjacent electrode tubes, and the electrode core is inserted into the plurality of electrode tubes, and is respectively connected to the plurality of electrode tubes; and the electrode mesh is disposed along the extension direction of the electrode core, and is nested outside the plurality of electrode tubes. The present disclosure can solve the problems of electrode of high cost and short service life.

## Description

### TECHNICAL FIELD

The present disclosure belongs to the field of semiconductor technology, and particularly relates to a semiconductor process device.

### BACKGROUND

Adopting a radio frequency mode, an atomic layer deposition device achieves accurate control of film thickness by adding a precursor into a vacuum chamber during a process cycle period, and can be configured to deposit various films such as a SiO₂ film, a SiNx film, a TiN film, and an A1N film. Ionizing a process gas into plasma with a high-frequency electric field is a key technique of a vertical atomic layer deposition device, so that a plasma generation apparatus is one of key structures for ensuring implementation of the process.

At present, some plasma generation apparatuses adopt an electrode having multiple layers of nickel meshes woven outside, and since a nickel-mesh weaving process is high in cost and requires a large number of nickel materials, the electrode is high in cost and manufacturing difficulty. Meanwhile, a material of the electrode is soft, such that a length of the electrode can be easily changed due to an influence of gravity during the use of the electrode, which affects service life of the electrode.

### SUMMARY

An objective of embodiments of the present disclosure is to provide a semiconductor process device capable of solving the above technical problem.

In order to solve the above technical problem, the present disclosure is implemented as follows.

The embodiments of the present disclosure provide a semiconductor process device, including: a process pipe and electrode groups;
a process chamber and a buffer chamber are formed inside the process pipe, the buffer chamber is communicated with the process chamber and arranged corresponding to at least one of the electrode groups, one end of each of the electrode groups penetrates through a sidewall of the process chamber and extends into the buffer chamber, and the other end of each of the electrode groups is configured to be connected to a radio frequency power supply, wherein
each of the electrode groups includes two electrode assemblies, which are configured to be connected to a positive electrode and a negative electrode of the radio frequency power supply, respectively; each of the electrode assemblies includes a deformable electrode core, a plurality of electrode tubes, and an electrode mesh, the plurality of electrode tubes are sequentially arranged along an extension direction of the electrode core, a preset gap is provided between every two adjacent electrode tubes, and the electrode core is inserted into the plurality of electrode tubes, and is respectively connected to the plurality of electrode tubes; and the electrode mesh is disposed along the extension direction of the electrode core, and is nested outside the plurality of electrode tubes.

Compared with some existing plasma generation apparatuses adopting the electrode having the multiple layers of nickel meshes woven outside, the semiconductor process device in the embodiments of the present disclosure adopts the novel electrode assembly, in which the deformable electrode core can be supported and protected by the plurality of electrode tubes, so that an overall strength of the electrode assembly can be improved. Therefore, a length of the electrode assembly is not prone to change under the action of gravity, so that service life of the electrode assembly can be prolonged. Meanwhile, for the electrode assembly in the embodiments of the present disclosure, instead of disposing multiple players of nickel meshes outside the electrode core, the plurality of electrode tubes are sequentially nested outside the electrode core along the extension direction of the electrode core, and the electrode mesh is nested outside the plurality of electrode tubes. Such arrangement can reduce the usage amount of nickel meshes, and obviate the need to dispose the multiple layers of nickel meshes, thereby reducing manufacturing cost and manufacturing difficulty of the electrode assembly. Thus, service life of the semiconductor process device can be ensured

### BRIEF DESCRIPTION OF DRAWINGS

FIG. 1 is a first schematic structural diagram of a semiconductor process device according to an embodiment of the present disclosure;
FIG. 2 is a second schematic structural diagram of a semiconductor process device according to an embodiment of the present disclosure;
FIG. 3 is a schematic structural diagram of a process pipe, a protective pipe, and a gas intake pipe according to an embodiment of the present disclosure;
FIG. 4 is a partial view of a process pipe, a protective pipe, a gas intake pipe, an electrode assembly, a first connecting assembly, and a second connecting assembly according to an embodiment of the present disclosure;
FIG. 5 is a partial view of an electrode assembly, a first connecting assembly, and a second connecting assembly according to an embodiment of the present disclosure;
FIG. 6 is a first schematic diagram of an electrode assembly according to an embodiment of the present disclosure; and
Fig. 7 is a second schematic diagram of an electrode assembly according to an embodiment of the present disclosure.

### DETAIL DESCRIPTION OF EMBODIMENTS

The technical solutions provided in the embodiments of the present disclosure are clearly and thoroughly described below with reference to the drawings for the embodiments of the present disclosure. Apparently, the embodiments described herein are just some embodiments of the present disclosure, and do not cover all embodiments. All other embodiments derived by those of ordinary skill in the art from the embodiments described herein without inventive work fall within the scope of the present disclosure.

The terms "first", "second" and the like in the description and the claims of the present disclosure are used for distinguishing between similar objects, but not necessarily for describing a particular order or a chronological order. It should be understood that the data such used may be interchanged under appropriate circumstances, so as to allow the embodiments of the present disclosure to be implemented in an order other than those illustrated or described herein; and the objects distinguished by the terms "first", "second" and the like generally belong to one kind, and the number of the objects is not limited, for example, the number of a first object may be one or more. In addition, the term "and/or" in the description and the claims indicates at least one of the objects connected by the term "and/or", and the forward slash "/" generally indicates that the object before "/" and the object after "/" are in an "or" relationship.

With reference to the drawings, the embodiments of the present disclosure are described in detail below in conjunction with specific embodiments and application scenarios.

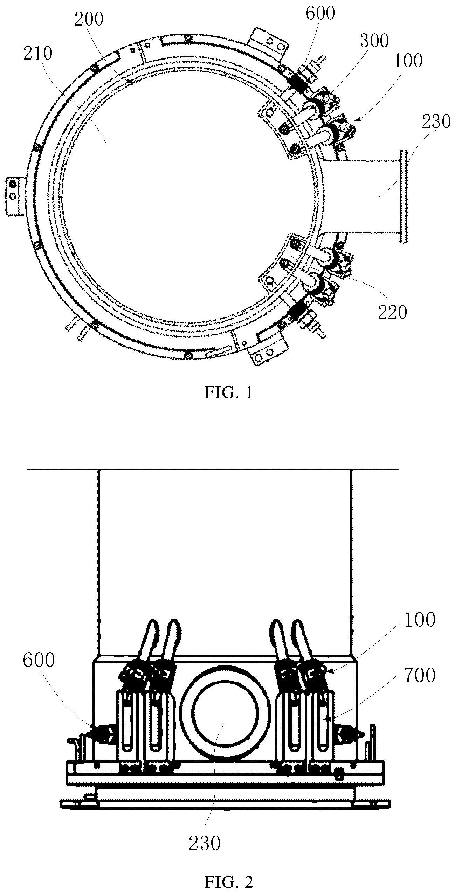

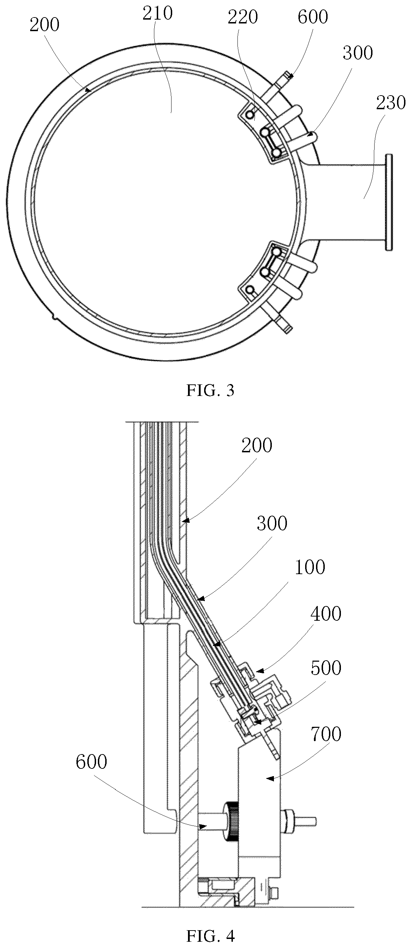

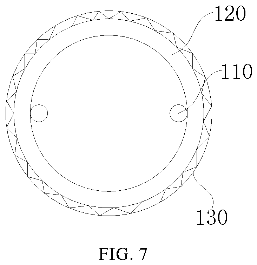

Referring to FIG. 1 to FIG. 7, an embodiment of the present disclosure provides a semiconductor process device, which may be a vertical atomic layer deposition device. Certainly, the semiconductor process device may be other devices, which are not particularly limited in the present disclosure. The provided semiconductor process device includes a process pipe 200 and electrode groups. A process chamber 210 and a buffer chamber 220 are formed inside the process pipe 200, the buffer chamber 220 is communicated with the process chamber 210, and is arranged corresponding to at least one electrode group, one end of each electrode group penetrates through a sidewall of the process chamber 210 and extends into the corresponding buffer chamber 220, and the other end of each electrode group is configured to be connected to a radio frequency power supply. Each electrode group includes two electrode assemblies 100, which are configured to be connected to a positive electrode and a negative electrode of the radio frequency power supply, respectively.

Optionally, a casing may be welded to the sidewall of the process pipe 200, so as to form the buffer chamber 220 inside the process pipe 200. Or, the buffer chamber 220 may be formed at the same time as the process pipe 200 is manufactured. The formation method of the buffer chamber 220 is not particularly limited in the embodiments of the present disclosure.

By providing the electrode assembly 100, a process gas in the buffer chamber 220 may be excited into a plasma state, so as to generate plasma, and the plasma enters the process chamber 210 from the buffer chamber 220 to process a wafer in the process chamber 210, during which the radio frequency power supply supplies power to the two electrode assemblies 100 of each electrode group through a radio frequency cable.

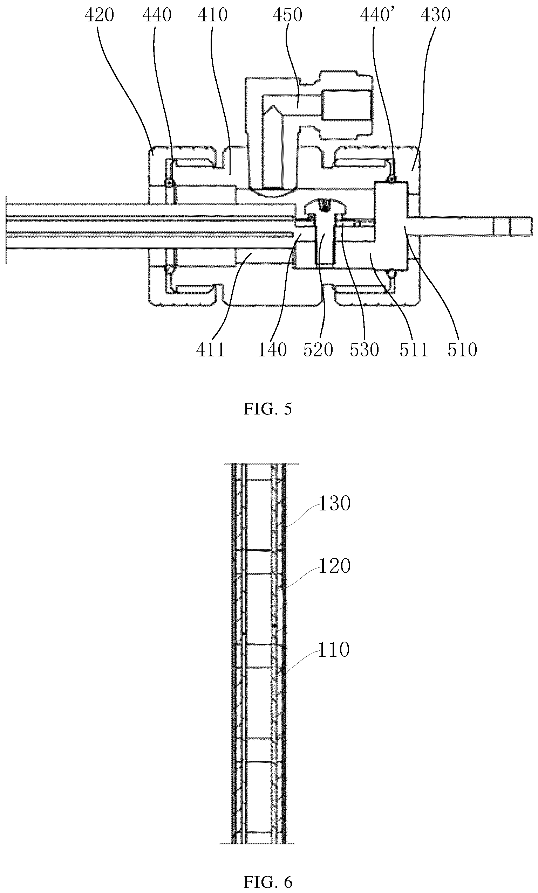

As shown in FIG. 6, each electrode assembly 100 includes an electrode core 110, a plurality of electrode tubes 120, and an electrode mesh 130, the plurality of electrode tubes 120 are sequentially arranged along an extension direction of the electrode core 110, a preset gap is provided between every two adjacent electrode tubes 120, the electrode core 110 is inserted into the plurality of electrode tubes 120 and is respectively connected to the plurality of electrode tubes 120, and the electrode mesh 130 is disposed along the extension direction of the electrode core 110 and is nested outside the plurality of electrode tubes 120. In this way, the strip-shaped electrode assembly 100 is formed by the electrode core 110, the plurality of electrode tubes 120, and the electrode mesh 130 together, so that the electrode assembly 100 may extend into the buffer chamber 220 to generate a high-frequency electric field; and as a result, the process gas introduced into the buffer chamber 220 may be excited to generate the plasma, and the plasma may enter the process chamber 210 from the buffer chamber 220 to achieve a process reaction.

Optionally, a length of the electrode tube 120 is in a range of 8mm to 16mm which includes 8mm, 10mm, 12mm, 14mm, 16mm, and the like. Certainly, the length of the electrode tube 120 may be other values. It should be noted here that the electrode tube 120 which is too long is not favorable for installation of the electrode assembly 100, and the electrode tube 120 which is too short may increase processing cost. Therefore, both installation requirements and cost requirements need to be considered in design and manufacturing of the electrode tube 120.

In order to enable the electrode assembly 100 to easily penetrate through the sidewall of the process pipe 200 and extend into the buffer chamber 220, the electrode core 110 in the embodiments of the present disclosure adopts a soft electrode core, so that the electrode core 110 is deformable and thus can adapt to an installation environment through deformation, so as to reduce installation difficulty of the electrode assembly 100.

In view of the fact that the soft electrode core 110 can easily affect the service life of the electrode assembly 100, for prolonging the service life of the electrode assembly 100, the electrode assembly 100 needs to be endowed with a sufficient strength. Based on this, the plurality of electrode tubes 120 are sequentially nested outside the electrode core 110 along the extension direction of the electrode core 110, so that the plurality of electrode tubes 120 can support and protect the electrode core 110, so as to improve an overall strength of the electrode assembly 100, thereby reducing a change in a length of the electrode assembly 100 during the use of the electrode assembly 100.

It should be noted here that the number of the electrode tubes 120 may be determined according to an overall length of the electrode assembly 100. When the electrode assembly 100 needs to be longer, the electrode core 110 is longer, so that more electrode tubes 120 are needed to be nested outside the electrode core 110; and when the electrode assembly 100 needs to be shorter, the electrode core 110 is shorter, so that fewer electrode tubes 120 are needed to be nested outside the electrode core 110.

In order to make the electrode assembly 100 deformable as a whole, the preset gap is provided between every two adjacent electrode tubes 120, leaving certain floating space between the two adjacent electrode tubes 120, so that the electrode assembly 100 can be deformed without causing interference, and overall flexibility of the electrode assembly 100 is ensured. Preferably, the preset gap is in a range of 30mm to 40mm which includes 30mm, 32mm, 35mm, 38mm, 40mm, and the like. Meanwhile, each electrode tube 120 can improve a local strength of the electrode assembly 100, thereby not only protecting the electrode core 110 but also reducing a change of a length of the electrode core 110.

By nesting the electrode mesh 130 outside the plurality of electrode tubes 120, a difference in electric field intensity caused by the preset gap between every two adjacent electrode tubes 120 can be compensated, so that the plasma can be distributed more uniformly in a direction of the electrode assembly 100.

Based on the above arrangement, optionally, the number of buffer chambers 220 may be more than one, a plurality of buffer chambers 220 are distributed along a circumferential direction of the process pipe 200, and are all communicated with the process chamber 210, and each buffer chamber 220 is arranged corresponding to at least one electrode group.

In the embodiments of the present disclosure, by providing the plurality of buffer chambers 220 and disposing the electrode assembly 100 corresponding to each buffer chamber 220, the process gas can be excited in the plurality of buffer chambers 220 at the same time. Compared with a single buffer chamber, the plurality of buffer chambers 220 are favorable for improvement in uniformity of the process.

The method of generating the plasma by respectively exciting the process gas in the plurality of buffer chambers 220 by the plurality of electrode assemblies 100 can reduce power consumption of each electrode assembly 100 under the same process condition, thereby facilitating prolonging the service life of the electrode assembly 100.

In the embodiments of the present disclosure, the number of the used buffer chambers 220 may be flexibly adjusted according to different process requirements, so that an increase of energy consumption due to an improper number of the used buffer chambers 220 can be avoided, which can produce the effects of energy conservation and emission reduction to a certain extent.

In some alternative embodiments, the semiconductor process device further includes a plurality of gas intake pipes 600, which penetrate through the sidewall of the process pipe 200 and extend into a plurality of buffer chambers 220 in a one-to-one correspondence manner for introducing the process gas into the corresponding buffer chambers 220, so as to meet demand for the process gas. Since the electrode assemblies 100 may form high-frequency electric fields in the buffer chambers 220, the process gas introduced into each buffer chamber 220 through the gas intake pipes 600 is excited into the plasma state under the action of the high-frequency electric fields to generate the plasma, and the plasma enters the inner chamber of the process pipe 200 from the buffer chambers 220 to participate in the process reaction.

An exhaust port 230 is provided at the sidewall of the process pipe 200, and is communicated with the process chamber 210 for discharging a gas from the process chamber 210. During each process, a process waste gas generated in the process chamber 210 may be discharged through the exhaust port 230, so as to avoid an excessive gas pressure in the process chamber 210.

After the process gas participates in the reaction, a reaction waste gas is generated in the process chamber 210, and may be discharged through the exhaust port 230, so that the gas pressure in the process chamber 210 can be maintained substantially balanced. Optionally, the exhaust port 230 may be connected to an external vacuum pumping device through an exhaust pipe, so as to discharge the reaction waste gas from the process chamber 210 with the vacuum pumping device. Moreover, a certain vacuum degree may be generated in the process chamber 210 under the action of the vacuum pumping device.

Compared with some existing plasma generation apparatuses adopting the electrode having the multiple layers of nickel meshes woven outside, the semiconductor process device in the embodiments of the present disclosure adopts the novel electrode assembly 100, in which the deformable electrode core 110 is supported and protected by the plurality of electrode tubes 120, so that the overall strength of the electrode assembly 100 can be improved. Therefore, the length of the electrode assembly 100 is not prone to change under the action of gravity, so that the service life of the electrode assembly 100 can be prolonged, so as to prevent the electrode assembly 100 from affecting uniformity of the plasma. Meanwhile, for the electrode assembly 100 in the embodiments of the present disclosure, instead of disposing multiple players of nickel meshes outside the electrode core 110, the plurality of electrode tubes 120 are sequentially nested outside the electrode core 110 along the extension direction of the electrode core 110, and the electrode mesh 130 is nested outside the plurality of electrode tubes 120. Such arrangement can reduce the usage amount of the nickel meshes, and obviate the need to dispose the multiple layers of nickel meshes, thereby reducing manufacturing cost and manufacturing difficulty of the electrode assembly 100.

In some embodiments, each electrode assembly 100 may include a plurality of electrode cores 110, each of which is inserted into the plurality of electrode tubes 120 and is fixedly connected to inner walls of the plurality of electrode tubes 120. Based on this, the plurality of electrode tubes 120 can support and protect the electrode cores 110, so as to improve the strength of the electrode assembly 100 while ensuring the overall flexibility of the electrode assembly 100, thereby prolonging the service life of the electrode assembly 100. Moreover, all the plurality of electrode cores 110 are respectively connected to the inner wall of each electrode tube 120, so that every two adjacent electrode tubes 120 can be connected to each other firmly and stably, so as to ensure the service life of the electrode assembly 100.

Optionally, the electrode cores 110 may be fixed to the inner walls of the electrode tubes 120 by welding or bonding, so that firmness of the connection of the electrode cores 110 to the inner walls of the electrode tubes 120 can be improved, which can prolong the service life of the electrode assembly 100.

In a specific embodiment, the electrode assembly 100 may include two electrode cores 110, which are fixedly connected to two opposite sides of the inner walls of the electrode tubes 120, respectively. In this way, the two opposite sides of the inner wall of each electrode tube 120 can be fixedly connected so make a force applied to each electrode tube 120 more uniform, so that stability of the connection of every two adjacent electrode tubes 120 can be ensured. Certainly, the electrode cores 110 included in the electrode assembly 100 may be in other numbers, and the number of the electrode cores 110 is not particularly limited in the embodiments of the present disclosure.

The electrode core 110 may be a nickel wire which has a small diameter and is soft, so as to enable the electrode assembly 100 to be freely deformed. Certainly, the electrode core 110 may be made of other materials and into other shapes, and the material and the shape of the electrode core 110 are not particularly limited in the embodiments of the present disclosure.

The electrode tube 120 may be a nickel tube which has a diameter larger than that of the nickel wire and is harder, so as to support and protect the electrode core 110 inserted in the electrode tube 120, thereby alleviating the problem that the service life is affected by the change of the length of the electrode core 110 due to deformation. Certainly, the electrode tube 120 may be made of other materials, and the material of the electrode tube 120 is not particularly limited in the embodiments of the present disclosure.

The electrode mesh 130 may be a nickel mesh. Under the condition of the same overall dimension of the electrode assembly 100, compared with the method of weaving multiple layers of nickel meshes outside the electrode core 110, the method of disposing the electrode tubes 120 outside the electrode core 110 and nesting the electrode mesh 130 outside the electrode tubes 120 obviates the need to weave the multiple layers of nickel meshes, and just needs a thin nickel mesh layer such as one layer of nickel mesh, so that the usage amount of nickel can be reduced, which can reduce the manufacturing cost and the manufacturing difficulty. Certainly, the electrode mesh 130 may be made of other materials, and the material of the electrode mesh 130 is not particularly limited in the embodiments of the present disclosure.

In some embodiments, two buffer chambers 220 are formed inside the process pipe 200, and are symmetrically arranged on two sides of the exhaust port 230. Based on this, the electrode assemblies 100 respectively excite the process gas into the plasma state in the two buffer chambers 220 to generate the plasma, and the plasma flows into the process chamber 210 from the two buffer chambers 220, which can improve the uniformity of the plasma in the process chamber 210 to improve film quality of a process product.

Certainly, more buffer chambers 220 may be disposed along the circumferential direction of the process pipe 200 and symmetrically distributed on the two sides of the exhaust port 230. In this way, by increasing the number of the buffer chambers 220 and equally distributing the plurality of buffer chambers 220 around the process chamber 210, a more uniform plasma atmosphere can be easily formed in the process chamber 210, thereby further improving uniformity of film thickness.

In the embodiments of the present disclosure, a plurality of through holes are provided on a side of each buffer chamber 220 away from the process pipe 200, and are arranged along an axial direction of the process pipe 200 for connecting the buffer chamber 220 to the process chamber 210. Based on this, a flow area of the process gas in the axial direction of the process pipe 200 can be increased, so that the process gas can be distributed more uniformly in the process chamber 210, so as to improve the film quality of the process product.

In some embodiments, the semiconductor process device may further include a protective pipe group, which includes at least one protective pipe 300, the protective pipe 300 penetrates through the sidewall of the process pipe and extends into the buffer chamber 220, and at least one electrode assembly 100 of the electrode group is inserted into the protective pipe 300. Moreover, optionally, the number of protective pipe groups is the same as the number of the electrode groups, and the protective pipe groups and the electrode groups are arranged in a one-to-one correspondence manner. Based on this, by inserting the at least one electrode assembly 100 into the protective pipe 300, on the one hand, the electrode assembly 100 can be mounted and guided through the protective pipe 300, so as to allow an end of the electrode assembly 100 to extend into the buffer chamber 220; and on the other hand, the protective pipe 300 can prevent contaminants from entering the process chamber 210 and protect the electrode assembly 100.

Optionally, the protective pipe 300 may be a quartz pipe. In addition, the protective pipe 300 may be fixed to the process pipe 200 by welding, bonding, clamping, or screwing, so as to ensure firmness and stability of the connection of the protective pipe 300 and the process pipe 200.

In a specific embodiment, one protective pipe group may include two protective pipes 300, and two electrode assemblies 100 of one electrode group are respectively inserted into the two protective pipes 300, and two electrode assemblies 100 of a same electrode group are respectively connected to the positive electrode and the negative electrode of the radio frequency power supply. Based on this, the two electrode assemblies 100 of each electrode group can be mounted and protected with two protective pipes 300, respectively.

In addition, when the electrode groups are mounted, lengths of the two electrode assemblies 100 of each electrode group in the two protective pipes 300 are kept the same as much as possible, so as to ensure uniformity of generated electric fields. Moreover, lengths of cables for connecting the two electrode assemblies 100 to the radio frequency power supply are kept the same as much as possible, so as to ensure consistency of phases of the two electric fields respectively generated by the two electrode assemblies 100.

In order to fix and seal the electrode assembly 100 to the protective pipe 300 and connect the electrode assembly 100 to the radio frequency power supply, the semiconductor process device may further include a first connecting assembly 400 and a second connecting assembly 500, which are provided for each electrode assembly 100. The first connecting assembly 400 is nested outside the protective pipe 300 and the second connecting assembly 500, and is respectively hermetically connected to the protective pipe 300 and the second connecting assembly 500, one end of the second connecting assembly 500 is connected to the electrode assembly 100, and the other end of the second connecting assembly 500 is configured to be connected to the radio frequency power supply. Based on this, with the first connecting assembly 400, the electrode assembly 100 can be mounted to and sealed with the protective pipe 300; and with the second connecting assembly 500, the electrode assembly 100 can be electrically connected to a radio frequency cable, and sealed with the first connecting assembly 400, so as to protect a joint of the second connecting assembly 500 and the electrode assembly 100, and avoid oxidation of the electrode assembly 100.

In order to further improve firmness and stability of the connection of the first connecting assembly 400 and the protective pipe 300 to improve firmness and stability of the installation of the electrode assembly 100, the semiconductor process device may further include a supporting block 700, which is fixed to a water-cooled pressure ring (not shown) of the semiconductor process device with a screw, and has a top butted to the first connecting assembly 400, so as to support the first connecting assembly 400. In this way, stable installation of the first connecting assembly 400 is realized through the cooperation of the supporting block 700 and the protective pipe 300, thereby improving the firmness and stability of the installation of the electrode assembly 100.

In some embodiments, the first connecting assembly 400 may include an electrode holder 410, a first locking member 420, and a second locking member 430. The electrode holder 410 is provided with a through cavity 411, one end of the electrode assembly 100 is disposed in the through cavity 411, at least part of the second connecting assembly 500 is disposed in the through cavity 411 and is connected to the electrode assembly 100, the electrode holder 410 is connected to the protective pipe 300 through the first locking member 420, and the second connecting assembly 500 is hermetically connected to the electrode holder 410 through the second locking member 430. Based on this, the assembly of the first connecting assembly 400 and the second connecting assembly 500 can be realized, and tightness of the assembly of the first connecting assembly 400 and the second connecting assembly 500 can be ensured.

In order to mount the first connecting assembly 400 to the protective pipe 300, the first locking member 420 may be disposed at an end of the protective pipe 300 away from the process pipe 200. When the first connecting assembly 400 needs to be mounted, just by connecting the electrode holder 410 to the first locking member 420, the first connecting assembly 400 may be mounted to the protective pipe 300.

Optionally, the first locking member 420 may be provided with an avoidance hole. The first locking member 420 may be regarded as a nut, and is nested outside an outer wall of the protective pipe 300 through the avoidance hole, and fixedly connected to the protective pipe 300; certainly, the first locking member 420 may be movably nested outside the protective pipe 300, and a blocking part may be provided outside the protective pipe 300 to prevent the first locking member 420 from being detached from the protective pipe 300. Based on this, installation stability of the first connection member 400 and the protective pipe 300 can be secured.

Optionally, the first locking member 420 may be connected to one end of the electrode holder 410 by threads, so that the first connecting assembly 400 may be detachably mounted to the protective pipe 300, so as to facilitate detaching the electrode holder 410, thereby facilitating replacement or maintenance of the electrode assembly 100.

Based on the above arrangement, when the electrode assembly 100 needs to be detached, just by separating the electrode holder 410 from the first locking member 420, the electrode holder 410 may be detached together with the electrode assembly 100, so as to facilitate the replacement or the maintenance of the electrode assembly 100.

Based on the arrangement that one end of the second connecting assembly 500 is located in the through cavity 411 and connected to the electrode assembly 100 and the other end of the second connecting assembly 500 is configured to be connected to the external radio frequency cable, the second locking member 430 is provided with an avoidance hole, so as to allow the other end of the second connecting assembly 500 to extend out of the through cavity 411, thereby facilitating the connection of the second connecting assembly 500 to the external radio frequency cable.

Optionally, the second locking member 430 may be connected to the other end of the electrode holder 410 by threads, and may be regarded as a nut, which can facilitate detachment. Based on this, when the second connecting assembly 500 does not need to be detached, the second locking member 430 is fastened to the other end of the electrode holder 410, and in this case, the second connecting assembly 500 may be firmly fixed to the electrode holder 410 through the second locking member 430, so as to prevent the second connecting assembly 500 from being detached from the electrode assembly 100 to affect energy transmission; and when the second connecting assembly 500 needs to be detached, just by detaching the second locking member 430 from the electrode holder 410 to remove the limiting effect on the second connecting assembly 500, the second connecting assembly 500 may be detached. In this way, the detachment of the second connecting assembly 500 is facilitated, which improves replacement efficiency or maintenance efficiency of the second connecting assembly 500.

In addition, since the joint of the electrode assembly 100 and the second connecting assembly 500 is located inside the through cavity 411, the electrode holder 410 can protect the joint of the electrode assembly 100 and the second connecting assembly 500 against interference from external factors.

In some embodiments, the semiconductor process device may further include a protective gas pipeline (not shown), a protective gas inlet 450 is provided at a sidewall of the through cavity 411, two protective pipes 300 of a same protective pipe group are hermetically communicated with each other in the corresponding buffer chamber 220, and the protective gas pipeline is communicated with an interior of the protective pipe 300 through the protective gas inlet 450 for introducing a protective gas.

Based on the above arrangement, an external protective gas (i.e., an anti-oxidation gas) may be introduced into the through cavity 411 through the protective gas inlet 450, flow into the buffer chamber 220 through one of the two protective pipes 300, and is discharged through the other of the two protective pipes 300. In this way, circulating flow of the protective gas is realized, so that the problem of unstable transmission due to the oxidation of the electrode assembly 100 can be effectively alleviated.

In order to achieve stable connection of the electrode assembly 100 and the second connecting assembly 500, the second connecting assembly 500 may include an electrode terminal 510 and a fastener 520. A first connecting end 511 of the electrode terminal 510 which is located in the through cavity 411 is provided with a first mounting hole, and a second connecting end 140 of the electrode assembly 100 which is located in the through cavity 411 is provided with a second mounting hole. During the installation, the first connecting end 511 and the second connecting end 140 overlap each other, and the fastener 520 is inserted into the first mounting hole and the second mounting hole in sequence to fasten the first connecting end 511 to the second connecting end 140.

Based on the above arrangement, by inserting the fastener 520 into the first mounting hole and the second mounting hole, dislocation of the first connecting end 511 and the second connecting end 140 relative to each other can be avoided, so that the first connecting end 511 and the second connecting end 140 can be effectively prevented from being detached from each other.

Further, the second connecting assembly 500 may further include a gasket 530, which is provided with a third mounting hole, and is disposed on a side of the second connecting end 140 away from the first connecting end 511. The first mounting hole, the second mounting hole, and the third mounting hole are arranged coaxially, the fastener 520 is inserted into the first mounting hole, the second mounting hole, and the third mounting hole, and the second connecting end 140 is pressed against the first connecting end 511 through the gasket 530, so that the second connecting end 140 and the first connecting end 511 are pressed against each other, thereby ensuring good contact between the first connecting end 511 and the second connecting end 140, and avoiding a virtual connection.

Based on the above arrangement provided in the embodiments of the present disclosure, firmness and stability of the connection of the first connecting end 511 and the second connecting end 140 can be ensured, and the virtual connection can be effectively avoided, so that stable transmission of electric energy can be achieved between the electrode assembly 100 and the second connecting assembly 500, with no electric energy loss.

Optionally, each of the first connecting end 511 and the second connecting end 140 may be a flat structure, so as to increase a contact area between the first connecting end 511 and the second connecting end 140, thereby further improving the stability of the connection.

In order to prevent external factors from entering the through cavity 411 to affect the joint of the electrode assembly 100 and the second connecting assembly 500, in some embodiments, a first sealing member 440 may be provided between the first locking member 420 and the electrode holder 410 to seal a gap between the first locking member 420 and the electrode holder 410.

In addition, a second sealing member 440' may be provided between the second locking member 430 and the electrode holder 410 to seal a gap between the second locking member 430 and the electrode holder 410.

Based on the above arrangement, with the first sealing member 440 and the second sealing member 440', the through cavity 411 can be sealed under the condition that the first locking member 420 is fastened to the electrode holder 410 and the second locking member 430 is fastened to the electrode holder 410, so that external impurities and the like can be prevented from entering the through cavity 411 to affect the joint of the electrode assembly 100 and the second connecting assembly 500, which ensures the stability and reliability of the connection of the electrode assembly 100 and the second connecting assembly 500.

Optionally, the first sealing member 440 and the second sealing member 440' may be both seal rings, which are respectively nested outside two ends of the electrode holder 410, so as to allow the electrode assembly 100 and the second connecting member 500 to extend out of the through cavity 411.

A working principle of the semiconductor process device according to the embodiments of the present disclosure is as follows:
the external radio frequency power supply transmits energy to the electrode assembly 100 through the radio frequency cable, so as to enable the electrode assembly 100 to generate the high-frequency electric field in the buffer chamber 220; and the process gas is introduced into the buffer chamber 220 through a process gas pipeline and the gas intake piped 600 in sequence, and is excited into the plasma state by the high-frequency electric field in the buffer chamber 220 to generate the plasma, and the plasma enters the process chamber 210 from the buffer chamber 220 to participate in the reaction, thereby realizing the process.

In summary, according to the embodiments of the present disclosure, by improving and optimizing the structure of the electrode assembly 100, the usage amount of a high-value material (e.g., nickel) can be reduced, so that cost and complexity of the electrode assembly 100 can be reduced. Moreover, by optimizing the structure of the electrode assembly 100, the strength of the electrode assembly 100 can be improved while ensuring overall flexibility of the electrode assembly 100, so that the service life of the electrode assembly 100 can be prolonged, and the reliability of the electrode assembly 100 can be improved.

By optimizing the layout of the buffer chambers 220 to improve distribution uniformity of the high-frequency electric fields, the uniformity of the plasma in the process chamber 210 can be improved, so as to improve process performance and ensure the uniformity of the film thickness.

The embodiments of the present disclosure are described above with reference to the drawings, but the present disclosure is not limited to the above specific implementations which are merely for illustration rather than for limitation. Enlightened by the present disclosure, those of ordinary skill in the art can make many variations without departing from the spirit of the present disclosure and the scope of the claims, and all those variations should be considered to fall within the scope of the present disclosure.

## Claims

1. A semiconductor process device, comprising: a process pipe and electrode groups;
wherein a process chamber and a buffer chamber are formed inside the process pipe, the buffer chamber is communicated with the process chamber and arranged corresponding to at least one of the electrode groups, one end of each of the electrode groups penetrates through a sidewall of the process chamber and extends into the buffer chamber, and the other end of each of the electrode groups is configured to be connected to a radio frequency power supply, wherein
each of the electrode groups comprises two electrode assemblies, which are configured to be connected to a positive electrode and a negative electrode of the radio frequency power supply, respectively; each of the electrode assemblies comprises a deformable electrode core, a plurality of electrode tubes, and an electrode mesh, the plurality of electrode tubes are sequentially arranged along an extension direction of the electrode core, a preset gap is provided between every two adjacent electrode tubes of the plurality of electrode tubes, and the electrode core is inserted into the plurality of electrode tubes, and is respectively connected to the plurality of electrode tubes; and the electrode mesh is disposed along the extension direction of the electrode core, and is nested outside the plurality of electrode tubes.

2. The semiconductor process device of claim 1, wherein each of the electrode assemblies comprises a plurality of electrode cores; and
each of the plurality of electrode cores is inserted into the plurality of electrode tubes, and is fixedly connected to inner walls of the plurality of electrode tubes.

3. The semiconductor process device of claim 1, wherein the electrode core is a nickel wire; and/or
the electrode tubes are nickel tubes; and/or
the electrode mesh is a nickel mesh.

4. The semiconductor process device of any one of claims 1 to 3, wherein a plurality of buffer chambers are provided and distributed along a circumferential direction of the process pipe, and are all communicated with the process chamber, and each of the plurality of buffer chambers is arranged corresponding to at least one of the electrode groups.

5. The semiconductor process device of claim 4, further comprising a plurality of gas intake pipes, which penetrate through the sidewall of the process pipe and extend into the plurality of buffer chambers in a one-to-one correspondence manner for introducing a process gas into the corresponding buffer chambers, wherein an exhaust port is provided at the sidewall of the process pipe, and is communicated with the process chamber for discharging a gas from the process chamber.

6. The semiconductor process device of claim 5, wherein the number of the buffer chambers is two, the two buffer chambers are symmetrically arranged on two sides of the exhaust port, and a plurality of through holes are provided on a side of each of the buffer chambers away from the process pipe, and are arranged along an axial direction of the process pipe for connecting each of the buffer chambers to the process chamber.

7. The semiconductor process device of any one of claims 1 to 3, further comprising a protective pipe group, which comprises at least one protective pipe, the protective pipe penetrates through the sidewall of the process pipe and extends into the buffer chamber, and at least one electrode assembly of the electrode groups is inserted into the protective pipe.

8. The semiconductor process device of claim 7, wherein the protective pipe group comprises two protective pipes, and two electrode assemblies of the electrode groups are respectively inserted into the two protective pipes.

9. The semiconductor process device of claim 8, further comprising a first connecting assembly and a second connecting assembly, which are provided for each electrode assembly; and
the first connecting assembly is nested outside the protective pipe and the second connecting assembly, and is respectively hermetically connected to the protective pipe and the second connecting assembly, one end of the second connecting assembly is connected to the electrode assembly, and the other end of the second connecting assembly is configured to be connected to the radio frequency power supply.

10. The semiconductor process device of claim 9, wherein the first connecting assembly comprises an electrode holder, a first locking member, and a second locking member;
the electrode holder is provided with a through cavity, one end of the electrode assembly is disposed in the through cavity, and at least part of the second connecting assembly is disposed in the through cavity and is connected to the electrode assembly; and
the electrode holder is hermetically connected to the protective pipe through the first locking member, and the second connecting assembly is hermetically connected to the electrode holder through the second locking member.

11. The semiconductor process device of claim 10, wherein the second connecting assembly comprises an electrode terminal and a fastener;
a first connecting end of the electrode terminal which is located in the through cavity is provided with a first mounting hole, and a second connecting end of the electrode assembly which is located in the through cavity is provided with a second mounting hole; and
the first connecting end and the second connecting end overlap each other, and the fastener is inserted into the first mounting hole and the second mounting hole in sequence to fasten the first connecting end to the second connecting end.

12. The semiconductor process device of claim 10, wherein a first sealing member is provided between the first locking member and the electrode holder to seal a gap between the first locking member and the electrode holder; and/or
a second sealing member is provided between the second locking member and the electrode holder to seal a gap between the second locking member and the electrode holder.

13. The semiconductor process device of claim 10, further comprising a protective gas pipeline; wherein
a protective gas inlet is provided at a sidewall of the through cavity, the two protective pipes of the same protective pipe group are hermetically communicated with each other in the corresponding buffer chamber, and the protective gas pipeline is communicated with an interior of the protective pipe through the protective gas inlet for introducing a protective gas.
